# DEMANDE DE BREVET EUROPEEN

(11) **EP 1 724 712 A1**
(43) Date de publication de la demande: **22.11.2006**
(21) Numéro de dépôt: 06007980.3
(22) Date de dépôt: 18.04.2006
(51) Int. Cl.: G06K 19/077

(54) **Micromodule, notamment pour carte à puce**

(30) Priorité: 11.05.2005 FR 0504701
(71) Demandeur: STMICROELECTRONICS SA, 92120 Montrouge (FR)
(72) Inventeur: Steffen, Francis, 83470 Saint Maximin (FR)
(74) Mandataire: Marchand, André

(57) **Abrégé**

L'invention concerne un micromodule électronique (50), notamment pour carte à puce, comprenant un substrat électriquement isolant (10), au moins une feuille conductrice (20) en un matériau électriquement conducteur, dont la face arrière est solidaire de la face avant du substrat, et une microplaquette de semiconducteur (30). Selon l'invention, le substrat (10) comporte un orifice (11) formant une fenêtre donnant accès à la face arrière de la feuille conductrice (20), la microplaquette (30) est agencée dans l'orifice et est fixée sur la face arrière de la feuille conductrice (20), et au moins un contact (32) de la microplaquette (30) est connecté électriquement à la face arrière de la feuille conductrice par l'intermédiaire d'un matériau de connexion électriquement conducteur (33). Application à la réalisation de cartes à puce, de badges électroniques et d'étiquettes électroniques.

## Description

La présente invention concerne un micromodule électronique, notamment pour carte à puce, comprenant un substrat électriquement isolant, au moins une feuille conductrice solidaire de la face avant du substrat et une microplaquette de semi-conducteur.

La présente invention concerne également un procédé de fabrication d'un tel micromodule électronique.

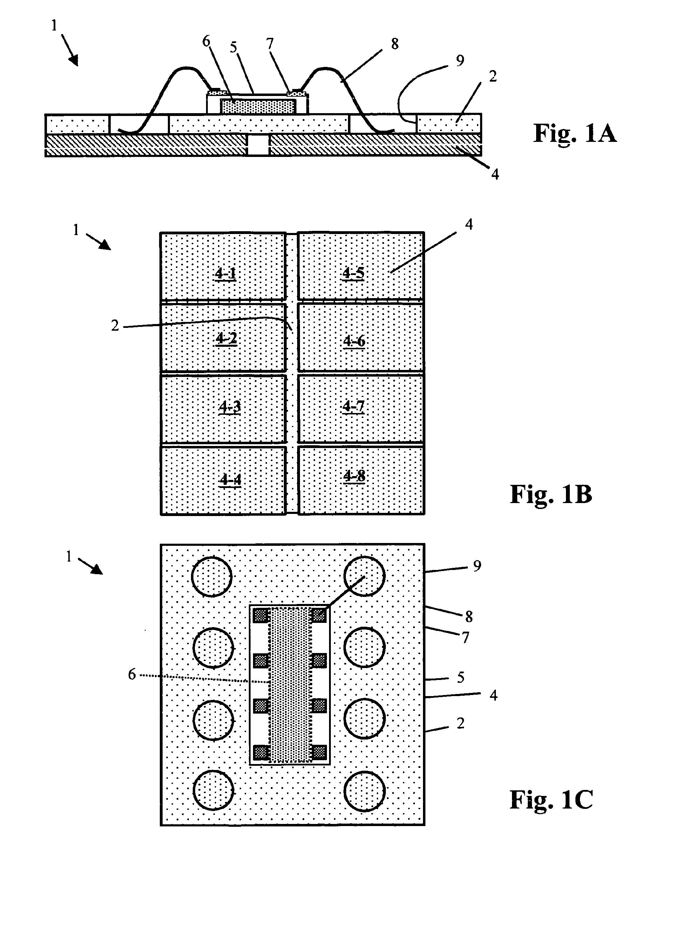

Les figures 1A, 1B, 1C représentent respectivement par une vue en coupe, une vue de dessus et une vue de dessous un micromodule électronique 1 classique. Le micromodule comprend un substrat 2 électriquement isolant, souple ou rigide. Sur la face avant du substrat (figure 1B) est fixée une feuille conductrice 4 qui a été gravée ou découpée pour former des plages conductrices, ici des plages conductrices 4-1 à 4-8 de type ISO 7816. Sur la face arrière du substrat (figure 1C) est fixée une microplaquette de silicium 5 ("chip") qui comprend une région de circuit intégré 6 et des contacts 7. Les contacts 7 sont reliés électriquement aux plages conductrices 4 par des fils métalliques 8 soudés aux ultrasons ("ultrasonic wire bonding"), l'extrémité distale de chaque fil étant soudée sur la face arrière des plages conductrices 4 en passant par des ouvertures 9 pratiquées dans le substrat 2.

Un tel micromodule électronique réalisé selon la technologie "puce et fil" ("chip and wire") est destiné à être monté sur une carte plastique pour former une carte à puce. Il permet également de réaliser des badges électroniques et autres objets portatifs de faible encombrement comprenant un circuit intégré.

Un tel micromodule présente toutefois divers inconvénients, considérés comme inhérents à sa structure même. D'une part, la technique de connexion par fils soudés aux ultrasons est coûteuse à mettre en oeuvre et son automatisation est peu compatible avec l'obtention d'un haut niveau de fiabilité des connexions électriques. D'autre part, l'épaisseur totale du micromodule n'est pas négligeable puisque à l'épaisseur de la microplaquette de silicium s'ajoute l'épaisseur du substrat, l'épaisseur des plages conductrices et la hauteur des boucles formées par les fils de câblage.

Ainsi, un objectif de la présente invention est de prévoir une structure de micromodule qui soit de faible épaisseur.

Un autre objectif de la présente invention est de prévoir une structure de micromodule peu coûteuse à réaliser et qui offre des connexions électriques fiables et se prêtant facilement à une automatisation de la production.

Encore un autre objectif de la présente invention est de prévoir un procédé de fabrication d'un micromodule qui ne nécessite pas de connecter les contacts de la microplaquette de silicium à la feuille conductrice en utilisant la technique de câblage ultrasonique.

Ces objectifs sont atteints par la prévision d'un micromodule électronique, notamment pour carte à puce, comprenant un substrat électriquement isolant, au moins une feuille conductrice en un matériau électriquement conducteur, dont la face arrière est solidaire de la face avant du substrat, et une microplaquette de semi-conducteur comprenant au moins un contact, dans lequel le substrat comporte un orifice formant une fenêtre donnant accès à la face arrière de la feuille conductrice, la microplaquette est agencée dans l'orifice et est fixée sur la face arrière de la feuille conductrice, et au moins un contact de la microplaquette est connecté électriquement à la face arrière de la feuille conductrice par l'intermédiaire d'un matériau de connexion électriquement conducteur.

Selon un mode de réalisation, la feuille conductrice forme des plages conductrices présentant chacune une région s'étendant en regard d'un contact de la microplaquette et reliée à celui-ci par le matériau de connexion.

Selon un mode de réalisation, la feuille conductrice forme une bobine d'antenne comprenant au moins deux régions s'étendant chacune en regard d'un contact de la microplaquette et reliée à celui-ci par le matériau de connexion.

Selon un mode de réalisation, la feuille conductrice est en cuivre.

Selon un mode de réalisation, le matériau de connexion est un bourrelet en un matériau fondu formant une soudure.

Selon un mode de réalisation, le matériau de connexion est un polymère comprenant des particules d'un matériau électriquement conducteur.

Selon un mode de réalisation, le micromodule comprend un matériau de remplissage s'étendant dans l'orifice entre la microplaquette et la face arrière de la feuille conductrice.

Selon un mode de réalisation, l'épaisseur de la microplaquette est inférieure à l'épaisseur du substrat, et la microplaquette ne dépasse pas de l'orifice.

La présente invention concerne également un objet portatif électronique comportant un micromodule électronique selon l'invention.

La présente invention concerne également un procédé de fabrication d'un micromodule électronique, notamment pour carte à puce, comprenant un substrat électriquement isolant, au moins une feuille conductrice en un matériau électriquement conducteur, dont la face arrière est solidaire de la face avant du substrat, et une microplaquette de semi-conducteur comprenant au moins un contact, procédé comprenant les étapes suivantes : formation d'un orifice dans le substrat, assemblage du substrat et de la feuille conductrice, de manière que l'orifice forme une fenêtre donnant accès à la face arrière de la feuille conductrice, montage de la microplaquette dans l'orifice, et connexion d'au moins un contact de la microplaquette à la face arrière de la feuille conductrice, au moyen d'un matériau de connexion électriquement conducteur.

Selon un mode de réalisation, le procédé comprend une étape de gravure ou de découpe de la feuille conductrice de manière à former un ou plusieurs éléments conducteurs.

Selon un mode de réalisation, le procédé comprend une étape de gravure de la feuille conductrice après son assemblage sur le substrat, effectuée dans une région de la feuille conductrice où sa face arrière est en contact avec le substrat, et une étape de découpe de la feuille conductrice dans une région de la feuille conductrice où sa face arrière s'étend devant l'orifice pratiqué dans le substrat.

Selon un mode de réalisation, le procédé comprend une étape de gravure ou de découpe de la feuille conductrice, avant que celle-ci ne soit assemblée sur le substrat, de manière à former un ou plusieurs éléments conducteurs maintenus à un cadre par des branches.

Selon un mode de réalisation, la feuille conductrice est gravée ou découpée de manière à faire apparaître des plages conductrices isolées électriquement les unes relativement aux autres et comprenant chacune une région s'étendant en regard d'un contact de la microplaquette.

Selon un mode de réalisation, la feuille conductrice est gravée ou découpée de manière à faire apparaître une bobine d'antenne qui comprend au moins deux régions s'étendant chacune en regard d'un contact de la microplaquette.

Selon un mode de réalisation, la feuille conductrice est en cuivre.

Selon un mode de réalisation, le matériau de connexion est un matériau fusible déposé sous forme de bourrelet.

Selon un mode de réalisation, le matériau de connexion est un matériau polymère comprenant des particules d'un matériau électriquement conducteur.

Selon un mode de réalisation, le procédé comprend une étape de dépôt d'un matériau de remplissage entre la face avant de microplaquette et la face arrière de la feuille conductrice.

Ces objectifs, caractéristiques et avantages ainsi que d'autres de la présente invention seront exposés plus en détail dans la description suivante de deux exemples de réalisation d'un micromodule selon l'invention et d'un exemple de procédé de fabrication du micromodule, faite à titre non limitatif en relation avec les figures jointes parmi lesquelles :
- les figures 1A, 1B, 1C précédemment décrites représentent respectivement par une vue en coupe, une vue de dessus et une vue de dessous un micromodule électronique classique pour carte à puce,
- les figures 2A, 2B, 2C représentent respectivement par une vue en coupe, une vue de dessus et une vue de dessous un premier exemple de réalisation d'un micromodule électronique selon l'invention,
- les figures 3A à 3E représentent des étapes d'un procédé de fabrication du micromodule selon l'invention,
- la figure 4 est une vue de dessus d'un masque de gravure utilisé pendant l'étape de la figure 3B,
- la figure 5 est une vue en coupe d'un outil de découpe utilisé pendant l'étape de la figure 3D,
- la figure 6 est une vue de dessus représentant un profil de feuille conductrice et illustre une variante du procédé illustré par les figures 3A à 3E, et
- la figure 7 est une vue de dessus d'un second exemple de réalisation d'un micromodule selon l'invention.

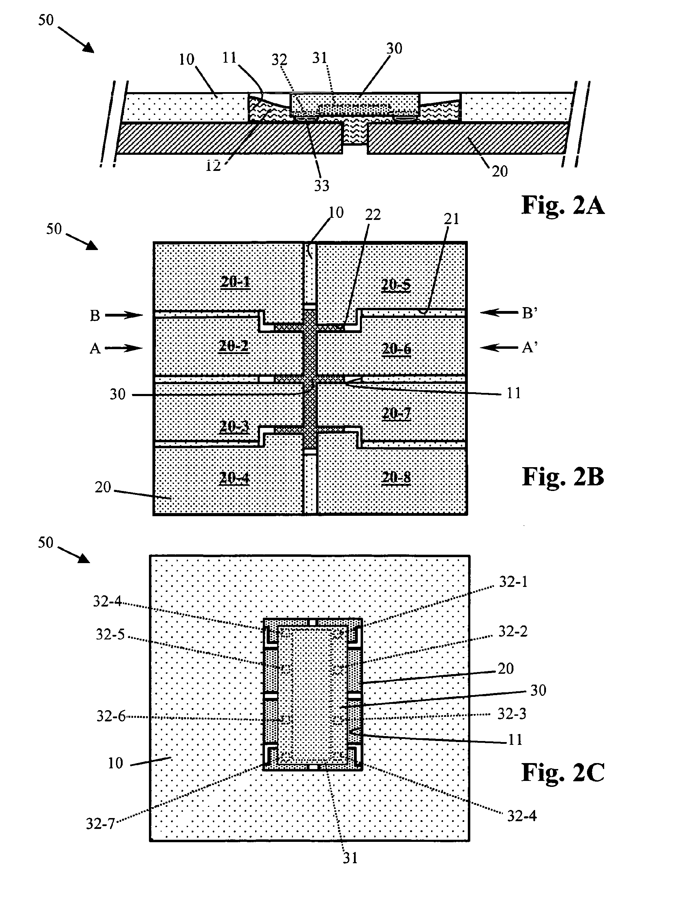

Un premier exemple de réalisation d'un micromodule électronique 50 selon l'invention est représenté sur les figures 2A, 2B, 2C respectivement par une vue en coupe, une vue de dessus et une vue de dessous, la vue en coupe de la figure 2A étant partielle et faite selon un axe AA' représenté en figure 2B.

Le micromodule 50 comprend de façon classique trois éléments de base, à savoir un substrat 10 électriquement isolant, une feuille conductrice 20 en un matériau électriquement conducteur et une microplaquette de silicium 30.

La microplaquette de silicium 30 comprend classiquement, sur sa face avant, une région de circuit intégré 31 et des contacts 32 (bornes métallisées) reliés électriquement à la région de circuit intégré, ici huit contacts 32-1 à 32-8 représentés par transparence sur la figure 2C. La feuille conductrice 20 est solidaire de la face avant du substrat 10 et est découpée ou gravée pour former des éléments conducteurs dont la forme dépend de l'application visée. La feuille conductrice 20 forme ici huit plages de contact 20-1 à 20-8 de type ISO 7816, délimitées par des zones de dépouille ou zones de séparation 21, 22 dépourvues de matériau conducteur.

Selon l'invention, le substrat 10 comporte un orifice central ou fenêtre 11 qui permet d'accéder à la face arrière de la feuille conductrice 20. Les zones de séparation 21 s'étendent au-dessus du substrat 10 et les zones de séparation 22 s'étendent au-dessus de la fenêtre 11.

Selon l'invention toujours, la microplaquette de silicium est agencée dans la cavité formée par la fenêtre 11, et est fixée sur la face arrière de la feuille conductrice 20 selon la technique dite "flip chip" ("puce retournée"), c'est à dire en ayant ses contacts 32 fixés sur la feuille 20 au moyen d'un matériau conducteur, formant ici des bourrelets 33 ("bumps"). A cet effet, les zones de séparation 22 sont agencées de manière que chaque plage de contact 20-1 à 20-8 présente une région s'étendant en regard d'un contact 32-1 à 32-8, et chaque contact 32-1 à 32-8 de la microplaquette de silicium est connecté ici au moyen d'un bourrelet conducteur 33 à la plage conductrice correspondante 20-1 à 20-8.

Les bourrelets conducteurs 32 sont par exemple en un alliage eutectique comme de l'étain-plomb ou de l'étain-or. Un matériau polymère conducteur, anisotrope ou non, chargé de particules métalliques, peut également être utilisé, les matériaux les plus couramment utilisés pour les connexions de type flip-chip étant les pâtes ou les films conducteurs anisotropes (ACP ou ACF). Les pâtes ou les films conducteurs anisotropes présentent la propriété de n'être électriquement conducteurs que dans le sens des contacts 32 vers les plages conductrices 20 (sens vertical sur la figure 2A) et peuvent ainsi être déposés sous forme d'une couche uniforme sans créer de court-circuit entre les contacts 32 (sens horizontal sur la figure 2A).

La cavité formée par la fenêtre 11 est remplie en tout ou en partie par un matériau électriquement isolant 12, qui s'étend en tout ou en partie sous la microplaquette de silicium 30, entre la face avant de la microplaquette et la face arrière de la feuille conductrice.

La rigidité du micromodule dans sa région centrale est assurée ainsi par l'assemblage microplaquette de silicium/plages de contact. Comme le silicium (et de façon générale tous types de semi-conducteurs susceptibles d'être utilisés pour réaliser des circuits intégrés) présente un module de Young nettement supérieur aux autres matériaux formant le micromodule, le micromodule selon l'invention présente une excellente résistance à la déformation.

Le substrat peut être en un matériau semi-rigide tel l'époxy ou en un matériau souple tel les diverses compositions de polymère utilisées dans l'industrie de l'électronique pour réaliser les substrats de type "flex".

Le micromodule présente typiquement une dimension de l'ordre de la dizaine de millimètres de côté, les dimensions des plages conductrices 20-1 à 20-8 étant par exemple de l'ordre de 2 x 3 mm. L'épaisseur du substrat 10 est par exemple de l'ordre de 100 à 200 micromètres auxquels s'ajoute l'épaisseur d'une couche de colle assurant l'assemblage du substrat 10 avec la feuille conductrice 20, typiquement de quelques dizaines de micromètres. La feuille conductrice 20 est par exemple une feuille de cuivre d'une épaisseur de quelques dizaines de micromètres, typiquement de l'ordre de 30 micromètres. L'épaisseur des bourrelets ou du matériau conducteur en couche est typiquement de l'ordre de la dizaine à quelques dizaines de micromètres, typiquement 20 micromètres pour des bourrelets conducteurs. L'épaisseur de la microplaquette de silicium 30, après abrasion de sa face arrière ("backlap") est de préférence inférieure à l'épaisseur du substrat 10, soit de l'ordre de 80 à 160 micromètres, afin que la microplaquette ne dépasse pas de l'orifice dans lequel elle est agencée, formé par la fenêtre 11.

L'invention permet ainsi de réaliser un micromodule de faible épaisseur, avec un gain en épaisseur au moins égal à l'épaisseur de la microplaquette 30, sans compter la hauteur des boucles formées par les fils de connexion dans les micromodules de type "puce et fils".

De plus, comme la microplaquette est agencée dans l'orifice 11, l'invention permet, pour une épaisseur donnée du micromodule 50, d'utiliser une microplaquette de silicium de plus forte épaisseur qu'avec un micromodule classique. En effet, pour diminuer l'épaisseur des micromodules, on a été contraint dans l'art antérieur de diminuer de façon drastique l'épaisseur des microplaquettes de silicium, parfois jusqu'à 50 micromètres, au détriment de la solidité des microplaquettes et en obtenant des rendements de fabrication médiocres en raison de l'amincissement extrême des wafers de silicium avant leur découpe en microplaquettes individuelles.

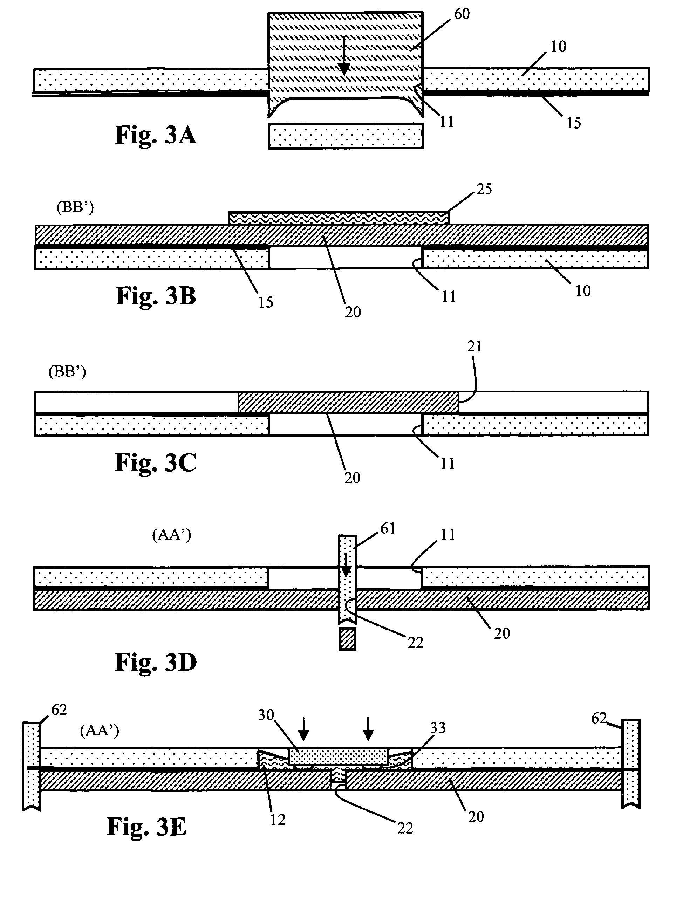

Les figures 3A à 3E sont des vues en coupe illustrant un procédé de fabrication du micromodule 50, les figures 3B, 3C étant des vues en coupe du micromodule en formation selon un axe BB' représenté en figure 2B et les figures 3D, 3E des vues en coupe du micromodule selon l'axe AA' mentionné plus haut.

Bien que ces figures ne représentent qu'un seul micromodule en cours de fabrication, le procédé est de préférence mis en oeuvre pour fabriquer collectivement et simultanément plusieurs micromodules.

Au cours d'une étape illustrée en figure 3A, la fenêtre 11 est découpée dans une feuille 10 de matériau électriquement isolant, destinée à former le substrat. La fenêtre est par exemple réalisée par estampage (retrait simultané de tout un bloc de matériau) au moyen d'un outil de découpe 60 à bords tranchants de même forme que la fenêtre 11 à réaliser. La feuille isolante 10 est ici du type préencmi18 et est recouverte d'une couche de colle séchée 15 de quelques dizaines de micromètres d'épaisseur.

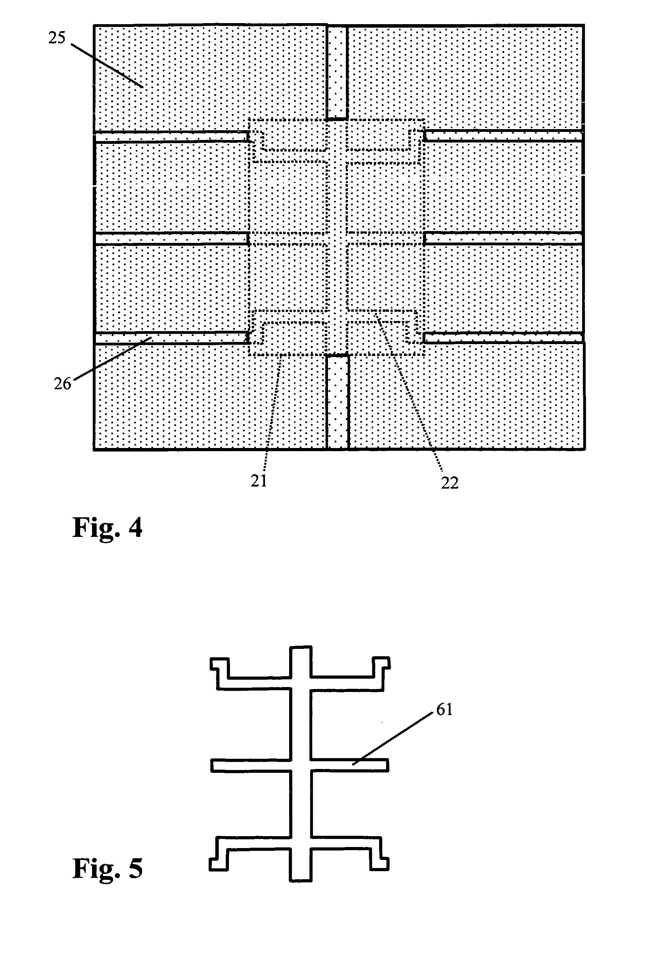

Au cours d'une étape illustrée en figure 3B, la feuille ou substrat 10 est assemblée avec une feuille 20 de matériau conducteur, par exemple en cuivre, grâce à la couche de colle 15. La face avant de la feuille 20 est ensuite recouverte avec un masque de gravure 25 et est mise en présence d'un agent de gravure (solution abrasive, plasma, jet de particules abrasives, etc.). Le profil du masque de gravure 25 est représenté en figure 4 par une vue de dessus. Le masque de gravure 25 présente des ouvertures 26 qui se trouvent en regard du substrat 10, et ne présente pas d'ouvertures dans la région coïncidant avec la fenêtre 11 (repérée par des traits pointillés). Les ouvertures 26 coïncident par leur forme et leur agencement aux zones de séparation 21 décrites plus haut (Cf. fig. 2B).

Ainsi, comme illustré en figure 3B, après gravure et retrait du masque de gravure 25, la feuille conductrice 20 présente les zones de séparation 21 qui s'étendent au-dessus du substrat 10, mais ne comporte pas les zones de séparation 22 (représentées en traits pointillés sur la figure 4) au-dessus de la fenêtre 11.

Les zones de séparation 22 permettant de séparer totalement les plages de contact 20-1 à 20-8 sont réalisées ici par estampage, au moyen d'un outil de découpe 61 dont le profil (section) est représenté en figure 5. L'opération est illustrée en figure 3D selon l'axe de coupe AA', suivant lequel les zones de séparation 21 précédemment réalisées n'apparaissent pas. L'outil 61 est appliqué sur la face arrière de la feuille conductrice 20 avec un mouvement de va et vient en passant par la fenêtre 11 pratiquée dans le substrat 10.

Au cours d'étapes finales illustrées en figure 3E, la microplaquette de silicium 30 est soudée sur la feuille conductrice 20 au moyen des bourrelets conducteurs 33, qui ont été préalablement déposés sur les contacts de la microplaquette. Le "soudage" (au sens de "bonding") est réalisé en présence de chaleur si un alliage eutectique est utilisé, ou à température ambiante si un polymère conducteur est utilisé. La face arrière de la feuille conductrice 20, dans la région recevant les bourrelets conducteurs 33, peut faire préalablement l'objet d'un traitement de surface garantissant l'accrochage du matériau conducteur, par exemple une désoxydation du cuivre ou le dépôt d'une couche d'accrochage de faible épaisseur, par exemple en Nickel, en Zinc-nickel ou en Palladium. Ce traitement peut être appliqué à tout instant avant le montage de la microplaquette 30, par exemple avant les étapes de gravure de la feuille conductrice 20 et d'assemblage de la feuille 20 avec le substrat 10.

Le matériau de remplissage 12 est ensuite injecté au moyen d'une seringue ou d'une buse de dispense en passant de préférence par la face avant de la plaque conductrice 20, c'est-à-dire en utilisant les zones de séparation 22 pour injecter le matériau 12, de manière à obtenir un bon étalement du matériau sous la microplaquette 30.

De façon optionnelle et notamment dans le cas d'une fabrication collective de micromodules à partir de feuilles conductrices et de feuilles isolantes de grandes dimensions, le périmètre du micromodule (carré, rectangulaire ou toute forme souhaitée) est découpé par estampage au moyen d'un outil tranchant 62 de forme correspondante.

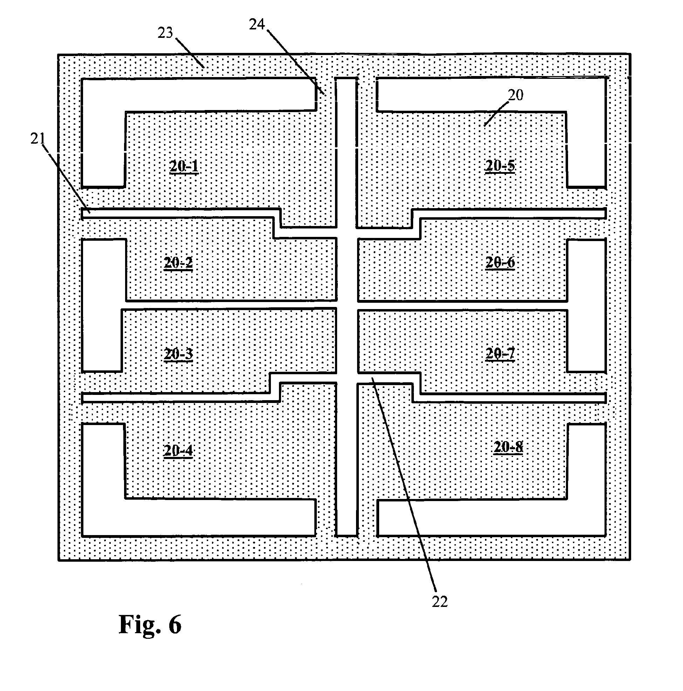

La figure 6 illustre une variante du procédé dans laquelle on applique une technique appelée "lead frame". Ici, les zones de séparation 21, 22 sont pratiquées dans la feuille conductrice 20 avant son assemblage avec le substrat 10, de sorte que les plages de contact 20-1 à 20-8 sont totalement individualisées. Celles-ci restent reliées à un cadre 23 par l'intermédiaire de branches 24 qui sont coupées lors de l'étape finale de délimitation des contours du micromodule au moyen de l'outil 62 susmentionné.

Il apparaîtra clairement à l'homme de l'art qu'un micromodule selon l'invention est susceptible de diverses variantes de réalisation et applications.

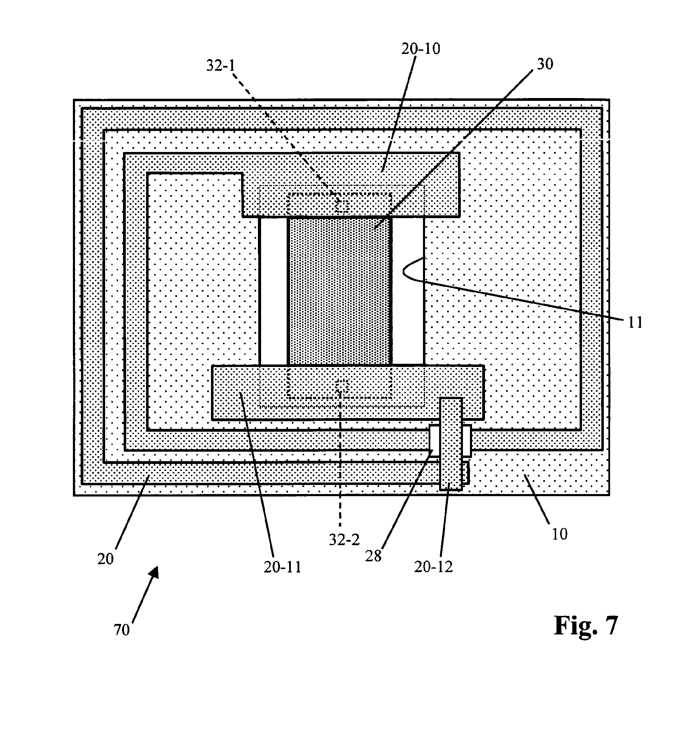

A titre d'exemple, la figure 7 est une vue de dessus d'un micromodule 70 qui se distingue du micromodule 50 en ce que la feuille conductrice 20 a été gravée ou découpée (ou gravée et découpée) de manière à former simultanément :
1) une bobine d'antenne présentant une spire interne qui se termine par une plage conductrice 20-10, et
2) une plage 20-11 qui, initialement, n'est pas reliée électriquement à la bobine d'antenne.

Les plages 20-10, 20-11 s'étendent partiellement au-dessus de la fenêtre 11 pratiquée dans le substrat 10. La microplaquette de silicium 30 présente deux contacts 32-1, 32-2 (représentés en traits pointillés, par transparence) qui sont soudés aux plages 20-10, 20-11 au moyen des bourrelets conducteurs précédemment décrits. La plage 20-11 est ensuite reliée électriquement à l'extrémité d'une spire externe de la bobine d'antenne au moyen d'une bande conductrice 20-12 ("strap"). La bande 20-12 forme un pont conducteur et passe au-dessus de la spire interne dont elle est isolée électriquement par une pièce 28 de matériau isolant déposée localement sur la bobine.

Le micromodule 70 forme un micromodule sans contact au sens de la norme ISO 14443 ou de la norme ISO 15693 et la bobine d'antenne permet au circuit intégré formé dans la microplaquette 30 de recevoir ou d'envoyer des données par couplage inductif.

Le micromodule 70 peut être utilisé pour réaliser des cartes à puce sans contact, des badges électroniques sans contact, des étiquettes électroniques, en étant agencé sur un support portable ou noyé dans un support portable de faibles dimensions, notamment un support en forme de carte. Grâce à sa faible épaisseur, le micromodule peut également être inséré dans un objet ou un document, par exemple dans un livre pour la gestion de bibliothèques, dans un passeport, une carte d'identité, un permis de conduire, etc..

## Revendications

1. Micromodule électronique (50, 70), notamment pour carte à puce, comprenant :
- un substrat électriquement isolant (10),
- au moins une feuille conductrice (20) en un matériau électriquement conducteur, dont la face arrière est solidaire de la face avant du substrat, et
- une microplaquette de semi-conducteur (30) comprenant au moins un contact (32),
**caractérisé en ce que** :
- le substrat (10) comporte un orifice (11) formant une fenêtre donnant accès à la face arrière de la feuille conductrice (20),
- la microplaquette (30) est agencée dans l'orifice et est fixée sur la face arrière de la feuille conductrice (20), et
- au moins un contact (32) de la microplaquette (30) est connecté électriquement à la face arrière de la feuille conductrice par l'intermédiaire d'un matériau de connexion électriquement conducteur (33).

2. Micromodule (50) selon la revendication 1, dans lequel la feuille conductrice (20) forme des plages conductrices (20-1 à 20-8) présentant chacune une région s'étendant en regard d'un contact (32-1 à 32-8) de la microplaquette (30) et reliée à celui-ci par le matériau de connexion (33).

3. Micromodule (70) selon la revendication 1, dans lequel la feuille conductrice forme une bobine d'antenne comprenant au moins deux régions (20-10, 20-11) s'étendant chacune en regard d'un contact (32-1, 32-2) de la microplaquette (30) et reliée à celui-ci par le matériau de connexion (33).

4. Micromodule selon l'une des revendications 1 à 3, dans lequel la feuille conductrice (20) est en cuivre.

5. Micromodule selon l'une des revendications 1 à 4, dans lequel le matériau de connexion (33) est un bourrelet en un matériau fondu formant une soudure.

6. Micromodule selon l'une des revendications 1 à 4, dans lequel le matériau de connexion (33) est un polymère comprenant des particules d'un matériau électriquement conducteur.

7. Micromodule selon l'une des revendications 1 à 6, comprenant un matériau de remplissage (12) s'étendant dans l'orifice (11) entre la microplaquette (30) et la face arrière de la feuille conductrice (20).

8. Micromodule selon l'une des revendications 1 à 7, dans lequel l'épaisseur de la microplaquette (30) est inférieure à l'épaisseur du substrat (10), et la microplaquette ne dépasse pas de l'orifice (11).

9. Objet portatif électronique, comportant un micromodule électronique selon l'une des revendications 1 à 8.

10. Procédé de fabrication d'un micromodule électronique (50, 70), notamment pour carte à puce, comprenant un substrat électriquement isolant (10), au moins une feuille conductrice (20) en un matériau électriquement conducteur, dont la face arrière est solidaire de la face avant du substrat, et une microplaquette de semi-conducteur (30) comprenant au moins un contact (32),
procédé **caractérisé en ce qu'**il comprend les étapes suivantes :
- formation d'un orifice (11) dans le substrat (10),
- assemblage du substrat (10) et de la feuille conductrice (20), de manière que l'orifice (11) forme une fenêtre donnant accès à la face arrière de la feuille conductrice (20),
- montage de la microplaquette (30) dans l'orifice, et
- connexion d'au moins un contact (32) de la microplaquette (30) à la face arrière de la feuille conductrice, au moyen d'un matériau de connexion électriquement conducteur (33).

11. Procédé selon la revendication 10, comprenant une étape de gravure ou de découpe de la feuille conductrice de manière à former un ou plusieurs éléments conducteurs (20-1 à 20-8, 20-10, 20-11).

12. Procédé selon la revendication 11, comprenant :
- une étape de gravure de la feuille conductrice (20) après son assemblage sur le substrat (10), effectuée dans une région de la feuille conductrice où sa face arrière est en contact avec le substrat, et
- une étape de découpe de la feuille conductrice (20) dans une région de la feuille conductrice où sa face arrière s'étend devant l'orifice (11) pratiqué dans le substrat (10).

13. Procédé selon la revendication 11 comprenant une étape de gravure ou de découpe de la feuille conductrice, avant que celle-ci ne soit assemblée sur le substrat, de manière à former un ou plusieurs éléments conducteurs (20-1 à 20-8) maintenus à un cadre (23) par des branches (24).

14. Procédé selon l'une des revendications 11 à 13, dans lequel la feuille conductrice (20) est gravée ou découpée de manière à faire apparaître des plages conductrices (20-1 à 20-8) isolées électriquement les unes relativement aux autres et comprenant chacune une région s'étendant en regard d'un contact (32-1 à 32-8) de la microplaquette.

15. Procédé selon l'une des revendications 11 à 13, dans lequel la feuille conductrice est gravée ou découpée de manière à faire apparaître une bobine d'antenne qui comprend au moins deux régions (20-10, 20-11) s'étendant chacune en regard d'un contact de la microplaquette.

16. Procédé selon l'une des revendications 10 à 15, dans lequel la feuille conductrice (20) est en cuivre.

17. Procédé selon l'une des revendications 10 à 16, dans lequel le matériau de connexion (33) est un matériau fusible déposé sous forme de bourrelet.

18. Procédé selon l'une des revendications 10 à 16, dans lequel le matériau de connexion (33) est un matériau polymère comprenant des particules d'un matériau électriquement conducteur.

19. Procédé selon l'une des revendications 10 à 18, comprenant une étape de dépôt d'un matériau de remplissage (12) entre la face avant de microplaquette et la face arrière de la feuille conductrice.
